Europäisches Patentamt

European Patent Office

Office européen des brevets

(11) Publication number: **0 380 794**
**A2**

# (12) EUROPEAN PATENT APPLICATION

(21) Application number: 89123128.4

(51) Int. Cl.⁵: **G01D 4/00**

(22) Date of filing: 14.12.89

(30) Priority: 21.12.88 IT 6813488

(43) Date of publication of application:
08.08.90 Bulletin 90/32

(84) Designated Contracting States:
**BE CH DE ES FR GB LI**

(71) Applicant: **URMET S.p.A. Costruzioni
Elettro-Telefoniche
Via Bologna 188/C
I-10154 Torino(IT)**

(72) Inventor: **Mondardini, Massino
Via Mazzini 40
I-10123 Torino(IT)**

(74) Representative: **Modiano, Guido et al
MODIANO, JOSIF, PISANTY & STAUB
Modiano & Associati Via Meravigli, 16
I-20123 Milano(IT)**

(54) External consumption-detecting device for meter-equipped users supplied by distribution networks.

(57) The device comprises an optical sensor (17) which is applicable outside of the meter, is responsive to the movement of the index (11a) of the consumption indicator (11) of the meter and is adapted to produce a useful signal (SU) every time the index passes in front of said sensor; the useful signal is amplified and converted from analog to digital by square-wave forming and threshold-adapting means (20) in order to be sent on a data transmission network (RT), in particular on a telematic network.

FIG. 2

## EXTERNAL CONSUMPTION-DETECTING DEVICE FOR METER-EQUIPPED USERS SUPPLIED BY DISTRIBU-TION NETWORKS

The present invention relates to an external consumption-detecting device for users supplied by distribution networks, in particular consumptions of electric power, gas and water.

As is known, the consumptions of users supplied by a network are measured by means of adapted totalling meters which can be of the roller or dial type but in any case comprise a progressive totalling device and a consumption indication means or flow-meter.

In induction meters for electricity the consumption indicator is constituted by the armature disk itself which rotates between the polar expansions of the ammeter and voltmeter coils and is provided with an index constituted by a colored sector.

In meters for fluids (water or gas), generally of the turbine or paddle type, the consumption indicator is constituted by a pointer which is different from the totalling pointer and is connected to the flow sensor (turbine or paddle) with a transmission with a low reduction ratio so that the rotation rate of the pointer is slightly lower than the rotation rate of the sensor.

In both cases, the consumption indication is provided by the passage of the index of the indication means (colored sector or pointer) at a sight, for example a window or a generic reference.

The aim of the present invention is to provide a device which, when applied to the outside of the meter - therefore without requiring any modification thereof - allows detection of the movement of the index of the consumption indicator and transduction of said movement into a useful signal of the digital type which can be remote-transmitted to a center for data reception and concentration which is capable of processing said signal and converting it for various uses, in particular for the automated invoicing of consumption.

In order to achieve this important aim and other objects which will become apparent from the following detailed description, the present invention relates to an external consumption detector characterized in that it comprises an optical sensor which can be applied to the outside of the meter, is responsive to the movement of the index of the consumption indicator of said meter and is adapted to produce a useful signal upon every passage of the index in front of said sensor: the useful signal being amplified and subsequently converted from analog to digital by square-wave forming and threshold-adapting means to be sent onto a data transmission network, particularly onto a telematic network.

Further characteristics and advantages will become apparent from the following detailed description and with reference to the accompanying drawings, given by way of non-limitative example, wherein:

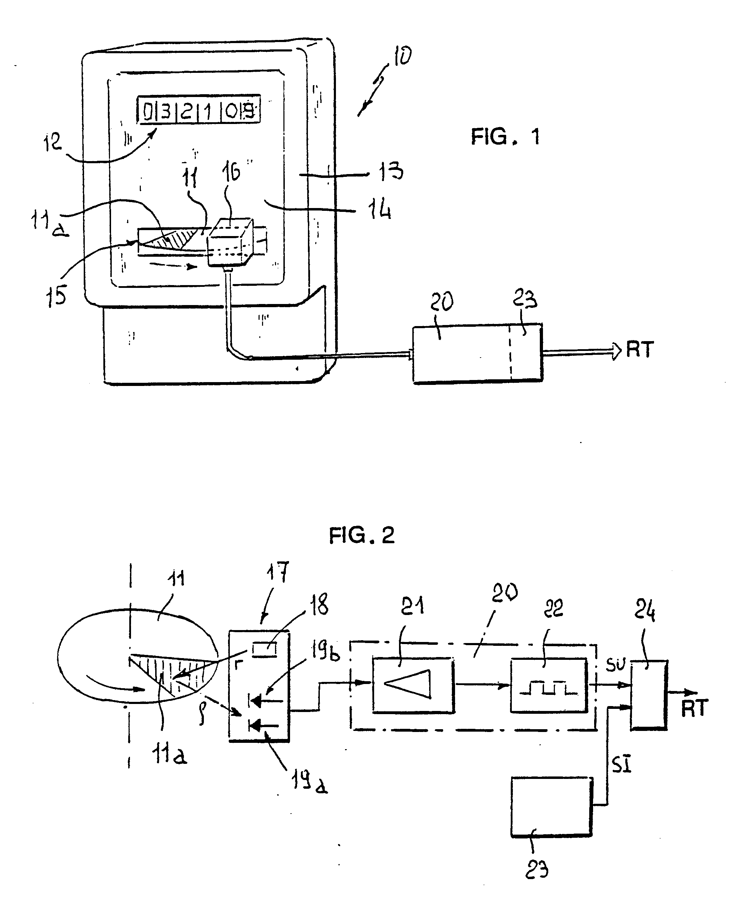

figure 1 is a perspective view of a conventional induction meter for measuring the consumption of electric power, equipped with the external detection device according to the present invention,

figure 2 is a block circuit diagram of the detection device,

figure 3 is a detailed circuit diagram of a preferred embodiment of the device.

In the drawings, 10 indicates an electric induction meter of the known kind which comprises an ammeter coil, a voltmeter coil (both of which are not illustrated) and an armature disk 11 which rotates between the polar expansions of said two coils and, by means of a gear transmission, actuates a decadic numeric totalling device 12 of the roller kind; the disk 11 and the totalling device 12 are visible from the outside through a front window of the case 13 of the meter which is protected by a glass pane 14.

The armature disk 11, which also acts as consumption indicator, is provided with a reference index constituted by a colored sector 11a which cyclically appears in a viewing port 15; the rotation rate of the disk is, as is known, a function of the absorbed power.

According to the present invention, a container 16 is arranged outside the case 13 of the meter 10 and at the viewing port 15 of the disk 11 and can be stably fixed to the meter by means of a supporting bracket or coupled to the protection pane 14 of the meter window by means of a sucker or the like.

The container 16 comprises an optical detector 17 which is responsive to the movement of the index 11a and is adapted to provide a useful signal of the analog type upon every passage of the index in front of the detector. For this purpose the detector 17 comprises an infrared-ray source 18 which is capable of concentrating and directing a preferably pulsating incident beam "r" onto the disk 11. The reflected beam "$\rho$" is received by at least one light sensor adapted to detect the modulation of said reflected beam produced by the passage of the index 11a.

The detector 17 preferably comprises a pair of light sensors 19a-19b for the purpose which will be specified hereafter.

The useful signal present at the output of the detector 17 is sent to a processing unit 20 composed by at least one amplifier stage 21 which is followed by at least one square-wave forming and threshold-adapting stage 22 which generates the useful digital signal SU. A generator 23 is also associated with the processing unit 20 and is adapted to emit a digital signal SI for identifying the meter, which is associated with the useful signal SU for addressing it; the two signals, the useful one and the address one, are sent onto a data transmission network, advantageously onto a telematic network RT by means of a port 24 for example of the parallel/serial type.

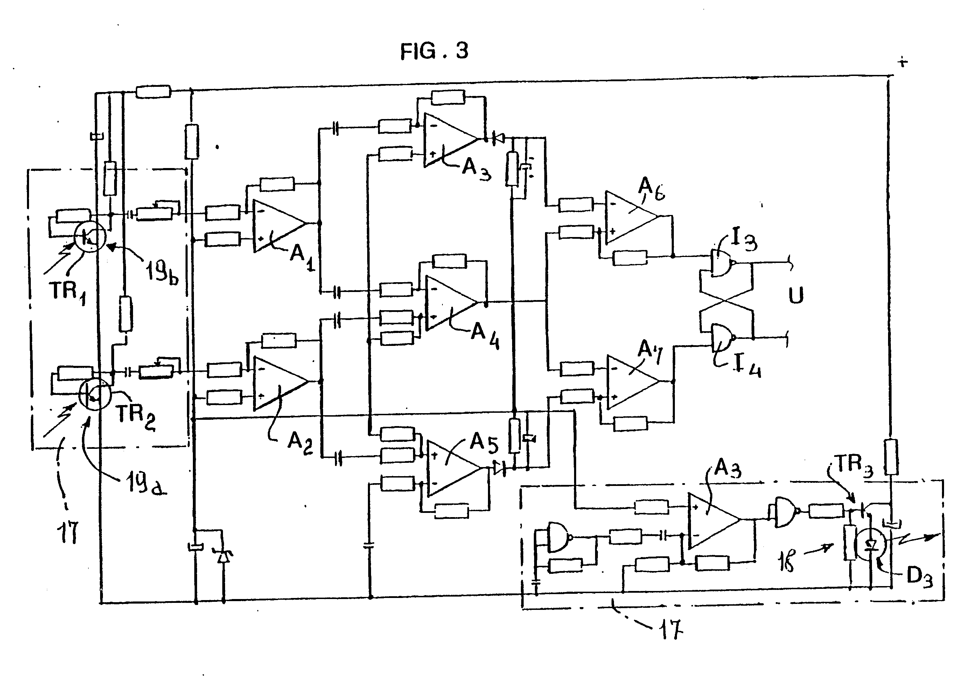

The diagram of figure 3 illustrates in detail a practical and preferred embodiment of the device according to the invention, and it can be seen that the source 18 which generates the incident beam "r" is constituted by an infrared-ray emitting diode D3 with an emission angle of +/-degrees. Said diode is pulse-powered with the double purpose of reducing power dissipation and of discriminating the infrared signal from noise possibly produced by other sources. A pulse generator composed of an oscillator A3, for example constituted by a section of a quadruple trigger/CMOS NAND (4093) in the square-wave oscillator configuration, is used for this purpose. The frequency of said oscillator is correlated to the maximum rotation rate of the disk 11 so that the light sensors 19 perform at least one sufficient series of readings (for example ten) during the passage of the index 11a. For a disk 11 which rotates for example at 2000 revolutions per hour, with a circumference of 300 mm and an index 11a which extends for an arc of circumference of 15 mm, this condition is verified by giving the oscillator A3 a frequency of 370 Hz. The pulses generated by the oscillator A3, further processed in a per se known manner by a shaper and by a trigger, are applied to a current amplifier transistor T3 which drives the diode D3.

The light sensors 19a-19b are constituted by phototransistors TR1-TR2 which are adapted to receive the infrared pulses reflected by the disk 11 and convert them into corresponding voltage pulses which, amplified by two operational amplifiers A1-A2, which define corresponding channels, are sent in the form of positive pulses to the successive processing stage, which comprises the functions of comparison of the signals of each channel and of threshold generation and level discrimination. The channel comparison function is performed by an operational amplifier A4 which determines the difference between the pulses arriving from the amplifiers A1 and A2 and amplifies said difference. Depending on the condition of the input pulses, positive or negative pulses are therefore present at the output of A4.

When the index 11a passes in front of the sensors TR1-TR2, a significant difference occurs in the level of the pulses, which are substantially constant and equal in the absence of said index. This difference constitutes the useful signal every time its intensity exceeds a preset threshold value. In order to avoid false signals which may arise from irregularities in the disk movement and/or reflection, two operational amplifiers A3,A5 are used with the function of generating crossed thresholds in that the pulses arriving from the amplifier A1 generate the threshold for those arriving from A2 and vice versa.

For this purpose, the positive or negative pulses present at the output of the operational amplifier A4 are sent to a double comparator A6-A7, crossed as indicated in the figure with those arriving from the threshold generators A3,A5, i.e. the output of A3 is sent to the negative input of A6 and the output of A5 is sent to the positive input of A7; the double comparator is suitable for producing negative pulses at the output every time the input pulses exceed the respective thresholds.

The pulses arriving from the comparators A6-A7 are sent to a set/reset flip-flop formed by two NAND gates I3-I4 and set the respective outputs thereof to the logical level "1". Consequent to the passage of the index 11a in front of the phototransistors TR1-TR2, for example, the momentary switching of the output U from the "0" level to the "1" level and then again to the "0" level is achieved, with the consequent generation of the useful digital signal SU.

The details of execution and the embodiments may naturally be extensively variated with respect to what is described and illustrated by way of non-limitative example without thereby altering the concept of the invention and without abandoning the scope thereof.

Where technical features mentioned in any claim are followed by reference signs, those reference signs have been included for the sole purpose of increasing the intelligibility of the claims and accordingly such reference signs do not have any limiting effect on the scope of each element identified by way of example by such reference signs.

## Claims

1. External consumption-detection device for meter-equipped users supplied by distribution networks, characterized in that it comprises an optical sensor which can be applied to the outside of said meter, is responsive to the movement of the index of the consumption indicator of said meter and is adapted to produce a useful signal upon every passage of the index in front of said sensor: the useful signal being amplified and converted from analog to digital by square-wave forming and threshold-adapting means to be sent onto a data transmission network, in particular onto a telematic network.

2. Device according to claim 1, characterized in that said optical sensor is accommodated in a container intended to be rigidly fixed to the meter at the consumption indication means.

3. Device according to claims 1 and 2, characterized in that said optical sensor comprises a source which generates a beam which is incident on the consumption indicator and light-sensor means adapted to detect the modulation of the beam reflected by said indicator which modulation is produced by the passage of the index of said indicator.

4. Device according to claim 3, characterized in that the emission of the incident beam is chosen in the range of infrared radiation.

5. Device according to claims 3 and 4, characterized in that said incident-beam generating source is constituted by an emitter diode.

6. Device according to claims 1 to 5, characterized in that said incident-beam generating source is pulse-powered and in that the frequency of said pulses is correlated to the rotation rate of the consumption indicator so that the emission of a sufficient number of pulses, for example comprised between ten and fifteen, corresponds to the passage time of the indicator index.

7. Device according to claims 1 to 6, characterized in that said emitter diode is powered by a pulse generator composed of an oscillator, a square-wave pulse shaper and a trigger, and in that said pulse generator is connected to the emitter diode with a current amplifier transistor interposed.

8. Device according to claims 1 to 3, characterized in that said light-sensing means of said optical sensor are constituted by a pair of phototransistors suitable for receiving the pulses of the beam reflected by the consumption indicator and for converting them into corresponding voltage pulses.

9. Device according to claims 1 and 8, characterized in that said voltage pulses produced by said phototransistors are separately amplified in corresponding differentiated channels and are sent, in the form of positive pulses, to a successive processing stage which comprises channel comparing, threshold generating and level-discrimination means, operatively connected to a flip-flop which forms the digital signal.

10. Device according to claim 9, characterized in that said channel comparing means comprise an operational amplifier adapted to determine the difference between the amplified signals arriving from the respective phototransistors, the signal at the output of said operational amplifier being positive or negative in relation to the condition of the input pulses.

11. Device according to claims 9 and 10, characterized in that said threshold generating means comprise a pair of operational amplifiers which generate crossed thresholds in that the pulses arriving from one channel generate the discrimination threshold for the pulses arriving from the other channel.

12. Device according to claims 9 to 11, characterized in that said level discrimination means comprise a double comparator formed by two operational amplifiers, the signals of the channel comparator and those of the crossed threshold generators being sent to the inputs of said operational amplifiers.

13. Device according to claims 9 to 12, characterized in that said flip-flop which forms the digital signal is of the set/reset type and comprises two NAND gates the outputs whereof are set to the "1" logical level by the input signal arriving from the respective operational amplifier of said double comparator.

FIG. 1

FIG. 2

FIG. 3